(19) Europäisches Patentamt
European Patent Office
Office européen des brevets

(11) **EP 2 539 411 B1**

(12) **EUROPEAN PATENT SPECIFICATION**

(45) Date of publication and mention
of the grant of the patent:
**05.08.2020 Bulletin 2020/32**

(51) Int Cl.:
***H01L 21/321*** (2006.01)     ***C09G 1/02*** (2006.01)

(21) Application number: **11744334.1**

(86) International application number:
**PCT/IB2011/050238**

(22) Date of filing: **19.01.2011**

(87) International publication number:
**WO 2011/101755 (25.08.2011 Gazette 2011/34)**

(54) **CHEMICAL-MECHANICAL PLANARIZATION OF SUBSTRATES CONTAINING COPPER, RUTHENIUM, AND TANTALUM LAYERS**

CHEMISCH-MECHANISCHE PLANARISIERUNG VON SUBSTRATEN MIT KUPFER-, RUTHENIUM- UND TANTALUMSCHICHTEN

PLANARISATION CHIMIQUE-MÉCANIQUE DE SUBSTRATS CONTENANT DES COUCHES DE CUIVRE, DE RUTHÉNIUM ET DE TANTALE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.02.2010 US 306559 P**

(43) Date of publication of application:
**02.01.2013 Bulletin 2013/01**

(73) Proprietor: **BASF SE**
**67056 Ludwigshafen am Rhein (DE)**

(72) Inventors:
• **LI, Yuzhuo**
**69123 Heidelberg (DE)**
• **WANG, Ke**
**Dalian 116600 (CN)**

(56) References cited:
**CN-A- 1 312 345      CN-A- 1 680 508**
**CN-A- 101 313 042      CN-A- 101 535 442**
**US-A1- 2008 057 715      US-A1- 2008 148 649**

## Description

### FIELD OF THE INVENTION

The present invention pertains to methods for chemically-mechanically polishing of substrates containing copper, ruthenium, and tantalum or tantalum nitride layers, or, more specifically, semiconductor substrates containing copper, ruthenium, tantalum or tantalum nitride, and dielectric layers.

### BACKGROUND OF THE INVENTION

Application of the damascene process to integrated circuit fabrication has resulted in aluminum being replaced by copper as the preferred electrical interconnect material because copper has a lower resistivity and better resistance to electromigration. Using the damascene process (which includes single and dual processes), the silicon oxide dielectric layer is etched to form patterns required for the designing of trenches or vias. A barrier layer is then deposited on the patterned dielectric layer prior to the deposition of copper, because copper can easily diffuse into the dielectric material to contaminate the device. Excess copper as well as the barrier layer is removed by using a process known as Chemical-Mechanical Polishing or Chemical-Mechanical Planarization (CMP), believed to be the only technique that simultaneously achieves global and local planarization.

The compositions used for CMP are customarily designated in the art as CMP agents, compositions or slurries.

Tantalum and tantalum nitride are currently used as barrier layer material to prevent device contamination caused by copper diffusing through the dielectric layer. However, it is difficult to deposit copper effectively onto the barrier layer due to the high resistivity of tantalum, especially in high-aspect ratio features. Consequently, a copper seed layer has to be initially deposited onto the barrier layer. As the feature size of the circuits are being reduced to the 65 nm, 45 nm and 32 nm scale, controlling the precise thickness of the seed layer to prevent overhang at the top of the trenches and the formation of voids becomes extremely difficult especially for 32 nm technology node and beyond.

Ruthenium has recently been identified as a promising barrier layer material candidate to replace the current tantalum barrier layer and the copper seed layer. The insolubility of copper in ruthenium makes ruthenium attractive as barrier layer material, and copper can also be directly deposited onto the ruthenium layer due to the lower resistivity of ruthenium. In addition, ruthenium is relatively easy to deposit onto the dielectric layer by physical vapor deposition (PVD), chemical vapor deposition (CVD) or atomic layer deposition (ALD) techniques. According to the advantageous properties of ruthenium, it can possibly replace the copper seed layer and tantalum layer. However, because of the current adhesion problem between ruthenium and dielectric layer, ruthenium and tantalum layers structure is more feasible now.

Due to the introduction of ruthenium into IC chips during the CMP process, copper, ruthenium and tantalum will be simultaneously exposed to CMP slurries, which is a huge challenge for CMP because of the different physical and chemical properties of the three kinds of metals. Consequently, selectivity becomes the paramount issue.

Copper is a soft material (Mohs hardness: 3) and chemically active. It is sensitive to abrasive hardness, abrasive concentration, down force and the pH value of the CMP slurry.

Tantalum is a hard (Mohs hardness 6.5) and chemically inert material. Most of the chemicals can not react with tantalum effectively at room temperature. So, the traditional tantalum barrier layer polishing process prefers to use high concentration (> 10 wt.%) of abrasives, a higher down force and a very alkaline (pH >10) or very acidic (pH < 3) slurry.

Ruthenium is a noble metal which is mechanically and chemically stable. Only some strong oxidants can react with ruthenium.

In addition, as the dimension of the copper line shrinks down, low-K dielectric material such as TEOS and PETEOS are used as inter-level dielectric (ILD) layers in order to reduce the inter-level capacitance. The low-K material is mechanically weak and chemically sensitive, so it cannot afford to use the CMP slurry containing a high concentration of abrasives or a high pH value, and it is also easily damaged by a high down force during polishing.

The ideal selectivity for copper: ruthenium: tantalum/tantalum nitride is 1:1:1. Current CMP slurries used for polishing barrier layers still have problems in tuning the material removal rate (MRR) of the different metal materials to meet the selectivity target.

Several proposals have been made in the prior art to ameliorate these problems and to approach this selectivity target.

Thus, the American patent US 6,869,336 B1 discloses compositions for the chemical-mechanical planarization using low contact pressures to remove ruthenium from substrates, the compositions comprising a dispersing medium, abrasive particles having a Mohs hardness in the range of 5 to 9 and a particle size in the range of 20 nm about 2 $\mu$ and having pH values in the range of 8 to 12, which compositions cause the ruthenium to be removed from the substrate as a ruthenium hydroxide. Alternative compositions have pH values in the range of 2.5 to 14 and cause the ruthenium to be removed from the substrate as a ruthenium oxide. Another class of alternative compositions have pH values below 2.5 and comprise a complexing agent, which causes the ruthenium to be removed as a ruthenium complex. These alternative compositions also contain an oxidizing agent selected from the group consisting of hydrogen peroxide, peroxosulfuric acid, periodic acid, monopersulfates, dipersulfates, and di-tert-butyl peroxide. The compositions may contain a passivation agent for copper suitable to reduce or prevent the corrosion of a copper layer overlying the ruthenium layer. The American patent furthermore discloses that the copper, ruthenium and dielectric layers are preferably polished with a polishing selectivity of 1:1:1. However, it remains silent as to how this selectivity target can be achieved.

The American patent US 7,265,055 B2 teaches a method for chemically-mechanically polishing a substrate comprising copper, ruthenium, tantalum, and dielectric layers. The method uses a polishing pad and a CMP composition or agent comprising alpha-alumina abrasive particles treated with a negatively-charged polymer or copolymer, hydrogen peroxide, an organic acid, at least one heterocyclic compound comprising at least one nitrogen atom, as for example benzenetriazole (BTA), a phosphonic acid, and water. The heterocyclic compound acts as a copper-corrosion inhibitor. The phosphonic acid increases the polishing rate of tantalum layer. Additionally, the CMP agent can contain a diamine compound comprising an ether group, the said compound suppressing the polishing rate of the tantalum layer. It is stated that the CMP agent allows for the polishing of the different substrate layers at substantially similar rates and with controllable selectivities. However, it appears that the tuning of the selectivities is complex.

The American patent application US 2008/0105652 A1 discloses a CMP agent of a pH of 6 to 12 comprising 0.01 to 10wt.% of an abrasive, 0.01 to 10wt.% of an oxidizing agent, 1 ppm to 5000 ppm of an amphiphilic non-ionic surfactant, 1 ppm to 500 ppm of calcium or magnesium ions, 0.001 to 0.5wt.% of a corrosion inhibitor for copper, and water. The oxidizing agent can be any suitable oxidizing agent, as for example, hydrogen peroxide, persulfate salts, ferric salts, solid forms of hydrogen peroxide, and combinations thereof. Solid forms of hydrogen peroxide include sodium percarbonates, calcium peroxide, and magnesium peroxide. It is stated that the relative selectivities for the polishing of copper, ruthenium, tantalum and dielectric layers can be controlled by selection of the abrasives (e.g., either alumina or a combination of alumina and silica) and by varying the nature and the amounts of the components present in the CMP composition. Thus, the copper removal rate can be increased by increasing the amount of abrasive and/or by incorporating an organic acid. Alternatively, the copper removal rate can be decreased by increasing the amount of corrosion inhibitor. The ruthenium removal rate can be decreased by using an abrasive comprising a combination of alumina and silica. The tantalum removal rate can be increased by increasing the amount of calcium or magnesium ions or by increasing the amount of oxidizing agent. The dielectric removal rate can be increased by using an abrasive comprising a combination of alumina and silica and by increasing the total amount of abrasive. Ammonium hydroxide causes an increase of the MRRs for copper and ruthenium and a decrease of the MRRs for tantalum and silicon oxide-based dielectrics. The relative MRRs of copper, ruthenium, tantalum and dielectric can be further tuned by utilizing a combination of ammonium hydroxide and potassium hydroxide. All in all, it can be concluded that the tuning of the selectivities of this prior art CMP composition is also complex.

US 2008/148649 A1 discloses a method of polishing a ruthenium layer with a slurry having a pH greater than 8 to 12 and comprising periodic acid or salt.

This complexity can lead to unforeseen problems when the relative selectivities of the prior art CMP compositions are tuned. Thus, the common approach in formulating these complex compositions is the use of an oxidizing agent, a complexing agent, a passivating agent, and abrasive particles. The use of a complexing agent and a passivating agent to tune metal removal rate is a classic approach. However, this often leads to either corrosion or other post-CMP problems. More specifically, a stronger complexing agent leads to corrosion and a stronger passivating agent leads to post-CMP residue.

## OBJECTS OF THE INVENTION

Therefore, there remains a need for improving the CMP methods for chemically-mechanically polishing of substrates, in particular, semiconductor substrates containing copper, ruthenium, and tantalum or tantalum nitride layers, or, more specifically, copper, ruthenium, tantalum or tantalum nitride, and dielectric layers. The improved to CMP methods should allow for the fine tuning of the relative selectivities of the various layers in a simple and straightforward manner without causing detrimental effects such as scratching, dishing, pitting, corrosion, post-CMP residues, and ILD damage.

## BRIEF SUMMARY OF THE INVENTION

According to the invention, a method as defined in claim 1 is provided.

## ADVANTAGES OF THE INVENTION

In view of the prior art, it was surprising and could not be expected by the skilled artisan, that the objects underlying the present invention could be solved by the CMP method of the invention.

It was particularly surprising that the CMP method of the invention significantly improved the chemical-mechanical polishing of substrates, in particular, semiconductor substrates containing copper, ruthenium, and tantalum or tantalum nitride layers, or, more specifically, copper, ruthenium, tantalum or tantalum nitride, and dielectric layers.

The CMP method of the invention unexpectedly allowed for the fine tuning of the relative selectivities of the various layers in a simple and straightforward manner without causing detrimental effects such as scratching, dishing, pitting, corrosion, post-CMP residues, and ILD damage.

In this way, the CMP method of the invention improved the manufacture of integrated circuits (ICs) with very large scale integration (VLSI) or ultra-large-scale integration (ULSI) and exceptional functionality and durability.

## DETAILED DESCRIPTION OF THE INVENTION

In its broadest aspect, the present invention is directed to a CMP method.

As the first essential ingredient, the CMP composition comprises at least one type of abrasive particles (a). In special cases, at least two, most preferably two types of abrasive particles (a) can be used. The function of the abrasive particles (a) is to enhance the material removal rate (MRR) during polishing. They also can carry away the debris removed from the metal layers to reduce defects on the polished surface.

Any suitable abrasive particles (a) known in the field of CMP can be incorporated into the CMP composition. Preferably, the abrasive particles (a) are selected from the group consisting of metal oxides, metal nitrides, metal carbides, silicides, borides, ceramics, diamonds, organic/inorganic hybrid particles, and mixtures thereof. Suitable abrasive particles (a) of these types are disclosed, for example, in the American patent application US 2008/0038995 A1, page 5, paragraph [0031] to page 7, paragraph [0048].

The abrasive particles (a) are preferably selected from the group consisting of silica, ceria, alumina, titania, zirconia, magnesia, titanium nitride, silicon carbide, diamond, and mixtures thereof with silica and alumina being most particularly preferably used.

The abrasive particles (a) can be optionally coated with any other kind of suitable organic or inorganic material or can optionally carry various functional groups such as hydroxyl groups or amino groups. Examples for suitable organic materials are the negatively-charged polymers and copolymers described in the American patent application US 2007/0090094 A1, page 2, paragraph [0016].

The average particle diameter of the abrasive particles (a) can vary broadly and, therefore, can be adapted most advantageously to particular requirements and conditions. Preferably, the average particle diameter ranges from 1 to 1000 nm, more preferably from 5 nm to 500 nm and, most preferably from 10 to 200 nm, as determined by electron microscopy.

Likewise, the concentration of the abrasive particles (a) can vary broadly and, therefore, can be adapted most advantageously to particular requirements and conditions. Preferably, the concentration ranges from 0.01 wt.% to 30 wt.%, preferably, from 0.1 wt.% to 10 wt.%, most preferably, from 0.5 wt.% to 6 wt.%, the weight percentages being based on the complete weight of the CMP composition.

The second essential ingredients of the CMP composition are the at least two, in particular two oxidizing agents (b). Their function in the CMP composition is radically different from the previous state of the art CMP compositions which just use the oxidizing agents to oxidize the substrate. In the CMP composition, they are used to tune the MRR of different metals, such as copper, ruthenium and tantalum to meet the target selectivity of the different metals.

In principle, any oxidizing agents known in the art of CMP can be selected for purposes of the invention. According to the invention, the two oxidizing agents (b) are selected such that one oxidizing agent (b1) is capable of increasing the material removal rate of a tantalum or tantalum nitride layer and the other oxidizing agent (b2) is capable of reacting with a ruthenium layer, and to simultaneously form a strong oxide film on a copper surface, which prevents too fast a removal of copper. Without wishing to be bound by a particular theory, it is believed that, as a result, the copper surface can be effectively protected and the MRR of copper can be easily tuned by the competition of the two oxidizing agents (b1) and (b2), and the MRR of ruthenium and tantalum or tantalum nitride can also be tuned by the interaction and competition of the two oxidizing agents (b1) and (b2). The function of the two oxidizing agents (b1) and (b2) can be further optimized by varying their concentrations. Therefore, in the CMP composition, a nearly neutral pH value ranging from 5 to 8 and in the CMP method of the invention a low down force can be used to meet the selectivity target.

According to the invention, the oxidizing agent (b1) is selected from persulfates, in particular potassium monopersulfate, and the oxidizing agent (b2) is selected from periodates, in particular sodium periodate.

The pH value of the CMP composition is in the range from 5 to 8.

The pH is adjusted by at least one pH adjusting agent (c) as the fourth essential ingredient of the CMP composition.

In principle, any known suitable pH adjusting agent (c) from the group consisting of inorganic and organic acids and bases can be used. More preferably, the inorganic acid (c) is selected from the group consisting of strong inorganic mineral acids; the organic acid (c) is selected from the group consisting of carboxylic acids, sulfonic acids, phosphonic acids, and mixtures thereof; the inorganic base (c) is selected from the group consisting of alkali metal hydroxides, ammonium hydroxide, and mixtures thereof; and the organic base (c) is selected from the group consisting of aliphatic and cycloaliphatic amines, quaternary ammonium hydroxides, and mixtures thereof.

PH adjusting agents (c) of these types are known, for example, from the American patent US 7,265,055 B2, column 7, lines 4 to column 8, line 6 and column 8, lines 16 to 35.

Most preferably, the pH adjusting agent (c) is selected from the group consisting of hydrochloric acid, nitric acid, sulfuric acid, phosphoric acid, oxalic acid, 1-hydroxyethylidene-1,1-diphosphonic acid, amino trimethylene phosphonic acid, potassium hydroxide, ammonium hydroxide and tetramethylammonium hydroxide.

Last but not least, the CMP composition contains deionized water (d) as the fourth essential ingredient.

In a adantageous embodiment, the CMP composition comprises at least one antioxidant (e). Its function, at least in part, is to compete with the oxidizing agents (b) in the CMP composition to further tune the selectivity of ruthenium, tantalum and copper. In addition, it can also balance the thickness of the copper oxide film during polishing to improve the surface quality of copper.

In principle, any suitable antioxidant (e) known from the art of CMP can be used for the purposes of the invention. Preferably, the antioxidants (e) are chosen from the group consisting of corrosion inhibitors, passivating agents and film forming agents, the functions and material compositions of which overlap with the antioxidant function to a great extent. Suitable corrosion inhibitors or film forming agents (e) are known, for example, from the American patent application US 2008/0038995 A1, page 8, paragraph [0062]. More preferably, the antioxidant (e) is selected from the group of heterocyclic compounds containing at least one nitrogen atoms. Suitable heterocyclic compounds (e) are known, for example, from the American patent US 7,265,055 B2, column 6, line 9 to column 7, line 3.

Most preferably, the antioxidant (e) comprises an azole group. Most particularly preferably, the antioxidant (c) is selected from the group consisting of benzotriazole, 1,2,4-triazole, 1,2,3-triazole, benzimidazole, 5-phenyl-1H-tetrazole, and mixtures thereof.

Optionally, the CMP composition can contain at least one functional additive (f).

In principle, any suitable functional additive (f) known from the art of CMP can be used in the CMP composition in the known and effective amounts. Preferably, the functional additive (f) is selected from the group consisting of organic solvents, negatively-charged polymers and copolymers, complexing and chelating agents, polyvalent metal ions, surfactants, rheology control agents, anti-foaming agents, biocides, and mixtures thereof.

Because of the unique combination of ingredients, the use of a passivating agent (f) and/or complexing agent (f) can be avoided. In one embodiment of the CMP composition, the amount of passivating agent (f) and/or complexing agent (f) is less 0.5wt.% based on the complete weight of the CMP composition. In another embodiment, the amount of passivating agent (f) and/or complexing agent (f) is less than 0.01 wt.% based on the total weight of the system. In one embodiment of the invention, no passivating agent (f) and/or complexing agent (f) is present in the inventive system so that the disadvantageous effects of their use can be avoided altogether.

The preparation of the CMP composition requires no particular methods and devices but can be carried out by dissolving or dispersing the above-described ingredients in an aqueous medium, in particular, deionized water in the desired amounts. For this purpose, the customary and standard mixing processes and mixing devices such as agitated vessels, in-line dissolvers, high shear impellers, ultrasonic mixers, homogenizer nozzles or counterflow mixers, can be used. Preferably, the CMP composition thus obtained can be filtered through filters of the appropriate mesh aperture, in order to remove coarse-grained particles such as the agglomerates or aggregates of the solid, finely dispersed abrasive particles (a).

The CMP composition is most excellently suited for chemically-mechanically polishing substrates comprising at least one copper layer, at least one ruthenium layer, and at least one tantalum or tantalum nitride layer. Preferably, the substrate also comprises a low-k or ultra-low-k dielectric material layer such as a metal oxide, a porous metal oxide, glass, organic polymers, fluorinated organic polymer, in particular silicon oxide derived from tetraethylorthosilicate (TEOS).

The metal layers can be disposed anywhere on the substrate, but preferably at least one copper layer and at least one ruthenium layer are in contact, and at least one tantalum or tantalum nitride layer is disposed between at least one ruthenium layer and at least one dielectric layer.

The substrate can be any suitable substrate, as for example, an integrated circuit (IC), a metal, an ILD layer, a semiconductor, or a thin film. Typically, the substrate comprises a patterned dielectric layer having a barrier layer comprising tantalum or tantalum nitride deposited thereon, a layer of ruthenium deposited onto the barrier layer, and an overcoating comprising copper. For example, a silicon wafer can be coated with a layer of a dielectric material. Trenches and vias defining circuit lines and circuit interconnects can be etched into the dielectric layer, after which a layer of the barrier material such as tantalum or tantalum nitride is deposited thereon using either a physical vapor deposition (PVD) or an atomic layer deposition (ALD) process. A layer of ruthenium is applied onto the tantalum or tantalum nitride layer using an ALD process, a PVD process, or a chemical vapor deposition (CVD) process. Finally, copper is deposited onto the ruthenium layer using an electroplating process or a CVD process.

Excess copper, ruthenium, and tantalum or tantalum nitride lying outside of the trenches and vias is then removed by a one or more chemical-mechanical polishing processes to expose the dielectric material between the substrate features, thereby isolating the conductive copper within the substrate features to define the circuit.

In particular, these CMP processes are carried out in accordance with the method of the invention comprising the steps as defined in claim 1.

As is known in the art, a typical equipment for the CMP consists of a rotating platen which is covered with the polishing pad. The substrate is mounted on a carrier or chuck with its upper side down facing the polishing pad. The carrier secures the substrate in the horizontal position. This particular arrangement of polishing and holding device is also known as the hard-platen design. The carrier may retain a carrier pad which lies between the retaining surface of the carrier and the surface of the substrate which is not being polished. This pad can operate as a cushion for the substrate.

Below the carrier, the larger diameter platen is also generally horizontally positioned and presents a surface parallel to that of the substrate to be polished. Its polishing pad contacts the substrate surface during the planarization process. During the CMP process of the invention, the CMP composition is applied onto the polishing pad as a continuous stream or in dropwise fashion.

Both the carrier and the platen are caused to rotate around their respective shafts extending perpendicular from the carrier and the platen. The rotating carrier shaft may remain fixed in position relative to the rotating platen or may oscillate horizontally relative to the platen. The direction of rotation of the carrier typically, though not necessarily, is the same as that of the platen. The speeds of rotation for the carrier and the platen are generally, though not necessarily, set at different values.

Customarily, the temperature of the platen is set at temperatures between 10 and 70°C.

Preferably, the down force during polishing is in the range of from 0 to 4 psi (0 to 27.58 kPa) and about 0.5 and 1.5 psi (3.45 to 10.34 kPa).

Preferably, the platen rotational speed speed is in the range of from 10 to 200 rpm.

Preferably, the carrier rotational speed is in the range of from 55 to 110 rpm

The CMP method of invention first removes the bulk of the overlying copper layer and then begins to remove first the underlying ruthenium layer and second, the underlying tantalum layer, with copper still available to the CMP composition. Advantageously, the CMP method of the invention allows for control of the selectivity for the polishing of the copper, ruthenium, tantalum, and dielectric layers. Selectivity is defined herein as the ratio of the MRR of one layer to the MRR of a second different layer.

Due to the most advantageous composition and balanced applicational properties of the CMP composition the selectivities can be excellently adjusted to the conditions and requirements of the CMP method of the invention.

Thus, the selectivity of ruthenium over tantalum (Ru:Ta) as measured by the MRR where no copper is removed is about (0.5 - 4.0):(1). In another embodiment of the CMP method of the invention, the selectivity of ruthenium over tantalum is about (1.0 - 3.0):(1).

In still another embodiment of the CMP method of the invention, the selectivity of ruthenium over tantalum over copper (Ru:Ta:Cu) as measured by the MRR is about (0.25 - 9.0):(0.25 - 4):(1).

In a further embodiment of the CMP method of the invention, the selectivity of ruthenium over tantalum over copper (Ru:Ta:Cu) as measured by the MRR where no antioxidant (e) has been added is about (1.0 - 10.0):(0.5 - 5):(1). In an additional embodiment for this CMP method of the invention, the selectivity of ruthenium over tantalum over copper is about (1.5 - 8.5):(0.75 - 3.5):(1).

In still another embodiment of the CMP method of the invention, the selectivity of ruthenium over tantalum over copper (Ru:Ta:Cu) as measured by the MRR where an antioxidant (e) has been added is about (0.25 - 5):(0.1 - 3):(1). In another embodiment for this CMP method of of the invention, the selectivity of ruthenium over tantalum over copper is about (0.4 - 3.5):(0.25 - 2.5):(1). In still another embodiment of the CMP method of the invention, the selectivity of ruthenium over tantalum over copper is about (0.4 - 0.9):(0.25 - 0.65):(1).

In addition to the advantages set out above, the dielectric material layers were not scratched or otherwise negatively affected during the CMP method of the invention.

EXAMPLES

Different polishing compositions were used in a CMP process conducted on separate substrates comprising copper, ruthenium and tantalum. The size of each substrate was $\Phi 1$ in $\times$ 0.2 in (2.51 cm x 0.502 cm). All the polishing work was done on a benchtop polisher (MetPrep 4™, High Tech Products, INC).

The MRRs were determined in the following way.

The substrates were conditioned, washed and dried. The polishing pad was conditioned with diamond grit conditioner to remove the products of the chemical reactions and to make the pad ready for the next run. After polishing, the substrates were cleaned with a deionized water rinse followed by an isopropyl alcohol rinse. Thereafter, the substrates were dried with a steady stream of pressurized air, and the MRR was calculated based on the net weight-loss in the polished surface area according to the calculation:

$$MRR = Weight\text{-}loss/(Density \times Area\ of\ Cross\text{-}section \times Time);$$

wherein

Weight-loss = loss of weight in copper disc after polish;
Density = density of copper;
Area of Cross-section = cross-section area of the disc; and
Time = polishing time.

The following examples demonstrate the effectiveness of the various polishing compositions on the selectivity of separate substrates comprising copper, ruthenium and tantalum.

EXAMPLE 1

Six similar sets of three substrates, each of which substrates separately included copper, ruthenium and tantalum, were polished with six different CMP compositions (CMP compositions 1, 2, 3, 4, 5 and 6). Each of the CMP compositions contained 5 wt.% of silica having a Moh's hardness of 6.5 and an average particle size of 50 nm. CMP composition 1 additionally comprised 0.3 wt.% of sodium periodate ($NaIO_4$) and 0.1 wt.% of potassium persulfate (KPS). CMP composition 2 additionally comprised 0.3 wt.% of sodium periodate and 0.2 wt.% of potassium persulfate. CMP composition 3 additionally comprised 0.3 wt.% of sodium periodate and 0.5 wt.% of potassium persulfate. CMP composition 4 additionally comprised 0.3 wt.% of sodium periodate and 1 wt.% of potassium persulfate. CMP composition 5 additionally comprised 0.3 CMP wt.% of sodium periodate and 2 wt.% of potassium persulfate. CMP composition 6 additionally comprised 0.5 wt.% of sodium periodate and 2 wt.% of potassium persulfate. The pH value of each composition was 5. The down force was 2 psi for each substrate. CMP time for each substrate was 60 seconds. The platen speed was 90 rpm and the carrier speed was 90 rpm. An IC 1000 pad was used in the CMP system. The slurry flow rate during CMP process was 200 ml/min. The approximate material removal rates (MRR) of (13.75 kPa) ruthenium, tantalum and copper from the tested substrates are shown in Table 1.

Table 1

| Polishing composition | SiO$_2$ (wt. %) | NaIO4 (wt. %) | KPS (wt. %) | Ru MRR (Å/min) | Ta MRR (Å/min) | Cu MRR (Å/min) |
|---|---|---|---|---|---|---|
| 1 | 5 | 0.3 | 0.1 | 486 | 262 | 0 |
| 2 | 5 | 0.3 | 0.2 | 729 | 297 | 0 |
| 3 | 5 | 0.3 | 0.5 | 842 | 345 | 0 |
| 4 | 5 | 0.3 | 1 | 1102 | 393 | 133 |
| 5 | 5 | 0.3 | 2 | 697 | 488 | 443 |
| 6 | 5 | 0.5 | 2 | 616 | 512 | 0 |

According to the results from Table 1, with different amount of sodium periodate and potassium persulfate used in the CMP compositions, the selectivity of ruthenium to tantalum to copper was able to be tuned easily. The MRRs of copper in the CMP composition 1 to 3 were approximate zero. In the CMP composition 1, the selectivity of ruthenium over tantalum was (1.9):(1); in the CMP composition 2, the selectivity of ruthenium over tantalum was (2.5):(1); in the CMP composition 3, the selectivity of ruthenium over tantalum was (2.4):(1); in the CMP composition 4, the selectivity of ruthenium to tantalum to copper was 8.3:3.0:1 in the CMP composition 5, the selectivity of ruthenium to tantalum to copper was (1.6):(1.1):(1); in the CMP composition 6, the selectivity of ruthenium over tantalum was: (1.2):(1), and the MRR of copper was zero.

The set of the results demonstrates the effectiveness of the CMP composition and the CMP process of the invention to chemically-mechanically polish substrates comprising ruthenium, tantalum and copper and also show the tunable ability of the selectivity of ruthenium, tantalum and copper.

EXAMPLE 2

Four similar sets of three substrates, each of which substrates separately included copper, ruthenium and tantalum, were polished with four different CMP compositions (CMP compositions 1, 2, 3 and 4). Each of the CMP compositions contained 5 wt.% of silica having a Mohs' hardness of 6.5 and a particle size of 50 nm, 0.3 wt.% of sodium periodate and 0.5 wt.% of potassium persulfate. CMP composition 1 additionally comprised 1 mM of benzotriazole (BTA). CMP composition 2 additionally comprised 1 mM of benzimidazole (BIA). CMP composition 3 additionally comprised 1 mM of 5-phenyl-1H-tetrazole (PTA). CMP composition 4 additionally comprised 1 mM of 1,2,4-triazole (TAZ). The pH value of each composition was 5. The down force was 2 psi (13.79 kPa) for each substrate. CMP time for each substrate was 60 seconds. The platen speed was 90 rpm and the carrier speed was 90 rpm. An IC 1000 pad was used in the CMP system. The slurry flow rate during CMP process was 200 ml/min. The approximate material removal rates (MRR) of ruthenium, tantalum and copper from the tested substrates are shown in Table 2.

Table 2

| Polishing composition | $SiO_2$ (wt. %) | NaIO4 (wt.%) | KPS (wt. %) | BTA (mM) | BIA (mM) | PTA (mM) | TAZ (mM) | Ru MRR (Å/min) | Ta MRR (Å/min) | Cu MRR (Å/min) |
|---|---|---|---|---|---|---|---|---|---|---|
| 1 | 5 | 0.3 | 0.5 | 1 | | | | 462 | 274 | 849 |
| 2 | 5 | 0.3 | 0.5 | | 1 | | | 340 | 238 | 421 |
| 3 | 5 | 0.3 | 0.5 | | | 1 | | 543 | 333 | 783 |
| 4 | 5 | 0.3 | 0.5 | | | | 1 | 429 | 274 | 133 |

Based on Table 2, it is exhibited that, the selectivity of ruthenium, tantalum and copper could be further adjusted by adding some antioxidant agents into the CMP compositions. In the CMP composition 1, the selectivity of ruthenium to tantalum to copper was (0.5):(0.3):(1); in the CMP composition 2, the selectivity of ruthenium to tantalum to copper was (0.8):(0.6):(1); in the CMP composition 3, the selectivity of ruthenium to tantalum to copper was (0.7):(0.4):(1); in the CMP composition 4, the selectivity of ruthenium to tantalum to copper was: (3.2):(2):(1).

In Table 2, the results further demonstrate the good ability of the CMP composition and the CMP method to control the selectivity of ruthenium, tantalum and copper during polishing process.


**Claims**

1. A method for the chemical-mechanical planarization of a substrate containing at least one copper layer, at least one ruthenium layer, and at least one tantalum or tantalum nitride layer comprising the steps of

   (1) providing a chemical-mechanical polishing composition containing

      (a) at least one type of abrasive particles;
      (b) at least one oxidizing agent (b1) selected from persulfates and at least one oxidizing agent (b2) selected from periodates as the oxidizing agents wherein the oxidizing agent (b1) is capable of increasing the material removal rate of the tantalum or tantalum nitride layer and the other oxidizing agent (b2) is capable of reacting with the ruthenium layer, and to simultaneously form a strong oxide film on the copper surface;
      (c) at least one pH adjusting agent;
      (d) deionized water;
      (e) optionally comprising at least one antioxidant,

      wherein the pH of the chemical-mechanical polishing composition ranges from 5 to 8;
      (2) contacting the substrate surface containing at least one copper layer, at least one ruthenium layer, and at least one tantalum or tantalum nitride layer to be polished with the chemical-mechanical polishing composition and a polishing pad; and
      (3) chemically and mechanically polishing the substrate surface containing at least one copper layer, at least one ruthenium layer, and at least one tantalum or tantalum nitride layer by way of moving the polishing pad relative to the substrate.

2. The method of claim 1, **characterized in that** the substrate additionally comprises a dielectric layer.

3. The method of claim 1 or 2, **characterized in that** the abrasive particles (a) are selected from the group consisting of metal oxides, metal nitrides, metal carbides, silicides, borides, ceramics, diamonds, organic/inorganic hybrid particles, and mixtures thereof.

4. The method of anyone of the claims 1 to 3, **characterized in that** the average particle diameter of the abrasive particles (a) ranges from 1 nm to 1000 nm.

5. The method of anyone of the claims 1 to 4 **characterized in that** the concentration of the abrasive particles (a) ranges from 0.1 wt.% to 10 wt.%, based on the complete weight of the chemical-mechanical polishing composition.

6. The method of anyone of the claims 1 to 5, **characterized in that** the concentration of each oxidizing agent (b) is about 0.001 wt.% to 10 wt.%, based on the complete weight of the chemical-mechanical polishing composition.

7. The method of anyone of the claims 1 to 6, **characterized in that** the pH adjusting (c) agent is selected from inorganic and organic acids and bases.

8. The method of claim 7, **characterized in that** the inorganic acid (c) is selected from the group consisting of strong inorganic mineral acids; the organic acid (c) is selected from the group consisting of carboxylic acids, sulfonic acids, phosphonic acids, and mixtures thereof; the inorganic base (c) he selected from the group consisting of alkali metal hydroxides, ammonium hydroxide, and mixtures thereof; and the organic base (d) is selected from the group consisting of aliphatic and cycloaliphatic amines, quaternary ammonium hydroxides, and mixtures thereof.

9. The method of anyone of the claims 1 to 8, **characterized in that** the antioxidant (e) is selected from the group of heterocyclic compounds containing at least one nitrogen atom, preferably the heterocyclic compound (e) is selected from the group consisting of benzotriazole, 1,2,4-triazole, 1,2,3-triazole, benzimidazole, 5-phenyl-1H-tetrazole, and mixtures thereof.

10. The method of claim 9, **characterized in that** the concentration of the ant ioxidant(e) is about 0.0001 wt.% to 1 wt.%, based on the complete weight of the chemical-mechanical polishing composition.

11. The method of anyone of the claims 1 to 10, **characterized in that** the chemicalmechanical polishing composition comprises at least one functional additive (f), wherein the functional additive (f) is selected from the group consisting of organic solvents, negatively-charged polymers and copolymers, complexing and chelating agents, polyvalent metal ions, surfactants, rheology control agents, anti-foaming agents, biocides, and mixtures thereof.

**Patentansprüche**

1. Verfahren zur chemisch-mechanischen Planarisierung eines Substrats mit mindestens einer Kupferschicht, mindestens einer Rutheniumschicht und mindestens einer Tantal- oder Tantalnitridschicht, das folgende Schritte umfasst:

   (1) Bereitstellen einer Zusammensetzung zum chemisch-mechanischen Polieren, enthaltend

      (a) mindestens einen Typ von Schleifteilchen;
      (b) mindestens ein Oxidationsmittel (b1), das aus Persulfaten ausgewählt ist, und mindestens ein Oxidationsmittel (b2), das aus Periodaten ausgewählt ist, als Oxidationsmittel, wobei das Oxidationsmittel (b1) dazu fähig ist, die Materialabtragsrate der Tantal- oder Tantalnitridschicht zu erhöhen, und das andere Oxidationsmittel (b2) dazu fähig ist, mit der Rutheniumschicht zu reagieren und gleichzeitig einen starken Oxidfilm auf der Kupferoberfläche zu bilden;
      (c) mindestens ein Mittel zur Einstellung des pH-Werts;
      (d) vollentsalztes Wasser;
      (e) gegebenenfalls umfassend mindestens ein Antioxidans;

   wobei der pH-Wert der Zusammensetzung zum chemisch-mechanischen Polieren im Bereich von 5 bis 8 liegt;
   (2) Inkontaktbringen der zu polierenden Substratoberfläche mit mindestens einer Kupferschicht, mindestens einer Rutheniumschicht und mindestens einer Tantal- oder Tantalnitridschicht mit der Zusammensetzung zum chemisch-mechanischen Polieren und einem Polierkissen und
   (3) chemisches und mechanisches Polieren der Substratoberfläche mit mindestens einer Kupferschicht, mindestens einer Rutheniumschicht und mindestens einer Tantal- oder Tantalnitridschicht durch Bewegen des Polierkissens relativ zum Substrat.

2. Verfahren nach Anspruch 1, **dadurch gekennzeichnet, dass** das Substrat zusätzlich eine dielektrische Schicht umfasst.

3. Verfahren nach Anspruch 1 oder 2, **dadurch gekennzeichnet, dass** die Schleifteilchen (a) aus der Gruppe bestehend aus Metalloxiden, Metallnitriden, Metallcarbiden, Siliciden, Boriden, Keramiken, Diamanten, organisch/anorganischen Hybridteilchen und Mischungen davon ausgewählt sind.

4. Verfahren nach einem der Ansprüche 1 bis 3, **dadurch gekennzeichnet, dass** der durchschnittliche Teilchendurchmesser der Schleifteilchen (a) im Bereich von 1 nm bis 1000 nm liegt.

5. Verfahren nach einem der Ansprüche 1 bis 4, **dadurch gekennzeichnet, dass** die Konzentration der Schleifteilchen (a) im Bereich von 0,1 Gew.-% bis 10 Gew.-%, bezogen auf das Gesamtgewicht der Zusammensetzung zum chemisch-mechanischen Polieren, liegt.

6. Verfahren nach einem der Ansprüche 1 bis 5, **dadurch gekennzeichnet, dass** die Konzentration jedes Oxidationsmittels (b) etwa 0,001 Gew.-% bis 10 Gew.-%, bezogen auf das Gesamtgewicht der Zusammensetzung zum chemisch-mechanischen Polieren, liegt.

7. Verfahren nach einem der Ansprüche 1 bis 6, **dadurch gekennzeichnet, dass** das Mittel zur Einstellung des pH-Werts (c) aus anorganischen und organischen Säuren und Basen ausgewählt ist.

8. Verfahren nach Anspruch 7, **dadurch gekennzeichnet, dass** die anorganische Säure (c) aus der Gruppe bestehend aus starken anorganischen Mineralsäuren ausgewählt ist; die organische Säure (c) aus der Gruppe bestehend aus Carbonsäuren, Sulfonsäuren, Phosphonsäuren und Mischungen davon ausgewählt ist; die anorganische Base (c) aus der Gruppe bestehend aus Alkalimetallhydroxiden, Ammoniumhydroxid und Mischungen davon ausgewählt ist und die organische Base (d) aus der Gruppe bestehend aus aliphatischen und cycloaliphatischen Aminen, quartären Ammoniumhydroxiden und Mischungen davon ausgewählt ist.

9. Verfahren nach einem der Ansprüche 1 bis 8, **dadurch gekennzeichnet, dass** das Antioxidans (e) aus der Gruppe bestehend aus heterocyclischen Verbindungen mit mindestens einem Stickstoffatom ausgewählt ist, vorzugsweise die heterocyclische Verbindung (e) aus der Gruppe bestehend aus Benzotriazol, 1,2,4-Triazol, 1,2,3-Triazol, Benzimidazol, 5-Phenyl-1H-tetrazol und Mischungen davon ausgewählt ist.

10. Verfahren nach Anspruch 9, **dadurch gekennzeichnet, dass** die Konzentration des Antioxidans (e) etwa 0,0001 Gew.-% bis 1 Gew.-%, bezogen auf das Gesamtgewicht der Zusammensetzung zum chemisch-mechanischen Polieren, beträgt.

11. Verfahren nach einem der Ansprüche 1 bis 10, **dadurch gekennzeichnet, dass** die Zusammensetzung zum chemisch-mechanischen Polieren mindestens ein funktionales Additiv (f) umfasst, wobei das funktionale Additiv (f) aus der Gruppe bestehend aus organischen Lösungsmitteln, negativ geladenen Polymeren und Copolymeren, Complex- und Chelatbildnern, mehrwertigen Metallionen, Tensiden, rheologiesteuernden Mitteln, Antischaummitteln, Bioziden und Mischungen davon ausgewählt ist.

**Revendications**

1. Procédé pour la planarisation mécano-chimique d'un substrat contenant au moins une couche de cuivre, au moins une couche de ruthénium, et au moins une couche de tantale ou de nitrure de tantale comprenant les étapes de

(1) mise à disposition d'une composition de polissage mécano-chimique contenant

(a) au moins un type de particules abrasives ;
(b) au moins un agent oxydant (b1) choisi parmi des persulfates et au moins un agent oxydant (b2) choisi parmi des periodates comme agents oxydants, l'agent oxydant (b1) étant capable d'augmenter la vitesse d'élimination de matière de la couche de tantale ou de nitrure de tantale et l'autre agent oxydant (b2) étant capable de réagir avec la couche de ruthénium, et de former simultanément un film d'oxyde fort sur la surface de cuivre ;
(c) au moins un agent d'ajustement du pH ;
(d) de l'eau désionisée ;

(e) éventuellement comprenant au moins un antioxydant,

le pH de la composition de polissage mécano-chimique se situant dans la plage de 5 à 8 ;
(2) mise en contact de la surface du substrat contenant au moins une couche de cuivre, au moins une couche de ruthénium, et au moins une couche de tantale ou de nitrure de tantale devant être polie avec la composition de polissage mécano-chimique et un tampon de polissage ; et
(3) polissage chimique et mécanique de la surface du substrat contenant au moins une couche de cuivre, au moins une couche de ruthénium, et au moins une couche de tantale ou de nitrure de tantale en déplaçant le tampon de polissage par rapport au substrat.

2. Procédé selon la revendication 1, **caractérisé en ce que** le substrat comprend de plus une couche diélectrique.

3. Procédé selon la revendication 1 ou 2, **caractérisé en ce que** les particules abrasives (a) sont choisies dans le groupe constitué par les oxydes métalliques, les nitrures métalliques, les carbures métalliques, les silicures, les borures, les céramiques, les diamants, les particules hybrides organiques/inorganiques, et des mélanges correspondants.

4. Procédé selon l'une quelconque des revendications 1 à 3, **caractérisé en ce que** le diamètre moyen de particule des particules abrasives (a) se situe dans la plage de 1 nm à 1 000 nm.

5. Procédé selon l'une quelconque des revendications 1 à 4 **caractérisé en ce que** la concentration de particules abrasives (a) se situe dans la plage de 0,1 % en poids à 10 % en poids, sur la base du poids complet de la composition de polissage mécano-chimique.

6. Procédé selon l'une quelconque des revendications 1 à 5, **caractérisé en ce que** la concentration de chaque agent oxydant (b) est d'environ 0,001 % en poids à 10 % en poids, sur la base du poids complet de la composition de polissage mécano-chimique.

7. Procédé selon l'une quelconque des revendications 1 à 6, **caractérisé en ce que** l'agent d'ajustement du pH (c) est choisi parmi des acides et des bases inorganiques et organiques.

8. Procédé selon la revendication 7, **caractérisé en ce que** l'acide inorganique (c) est choisi dans le groupe constitué par les acides minéraux inorganiques forts ; l'acide organique (c) est choisi dans le groupe constitué par les acides carboxyliques, les acides sulfoniques, les acides phosphoniques, et des mélanges correspondants ; la base inorganique (c) est choisie dans le groupe constitué par les hydroxydes de métal alcalin, l'hydroxyde d'ammonium, et des mélanges correspondants ; et la base organique (c) est choisie dans le groupe constitué par les amines aliphatiques et cycloaliphatiques, les hydroxydes d'ammonium quaternaires, et des mélanges correspondants.

9. Procédé selon l'une quelconque des revendications 1 à 8, **caractérisé en ce que** l'antioxydant (e) est choisi dans le groupe des composés hétérocycliques contenant au moins un atome d'azote, préférablement le composé hétérocyclique (e) étant choisi dans le groupe constitué par le benzotriazole, le 1,2,4-triazole, le 1,2,3-triazole, le benzimidazole, le 5-phényl-1H-tétrazole, et des mélanges correspondants.

10. Procédé selon la revendication 9, **caractérisé en ce que** la concentration de l'antioxydant (e) est d'environ 0,0001 % en poids à 1 % en poids, sur la base du poids complet de la composition de polissage mécano-chimique.

11. Procédé selon l'une quelconque de revendication 1 à 10, **caractérisé en ce que** la composition de polissage mécano-chimique comprend au moins un additif fonctionnel (f), l'additif fonctionnel (f) étant choisi dans le groupe constitué par les solvants organiques, les polymères et les copolymères chargés négativement, les agents complexants et chélatants, les ions métalliques polyvalents, les tensioactifs, les agents de régulation de la rhéologie, les agents antimousse, les biocides, et des mélanges correspondants.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6869336 B1
- US 7265055 B2
- US 20080105652 A1
- US 2008148649 A1
- US 20080038995 A1
- US 20070090094 A1